# EUROPEAN PATENT APPLICATION

(11) **EP 2 192 091 A1**
(43) Date of publication of application: **02.06.2010**
(21) Application number: 08020826.7
(22) Date of filing: 01.12.2008
(51) Int. Cl.: C03C 17/245, C23C 16/453

(54) **Process for providing super-hydrophilic properties to a substrate**

(71) Applicant: ETH Zurich, 8092 Zürich (CH)
(72) Inventor: Tricoli, Antonio, 8032 Zürich (CH); Righettoni, Marco, 8051 Zürich (CH); Pratsinis, Sotiris, E., 8032 Zürich (CH)

(57) **Abstract**

The present invention relates to a process for providing super-hydrophilic properties to a substrate by applying a coating comprising a photocatalytic and/or a hydrophilic coating material to a surface of the substrate.

The process comprises the steps of
a) combustion and/or pyrolysis of a precursor of the coating material in a flame, thereby producing a vapour and/or an aerosol comprising the coating material and
b) deposition of the coating material from the vapour or aerosol, respectively, to the substrate's surface.

## Description

The present invention relates to a process for providing super-hydrophilic properties to a substrate, according to claim 1, and to an object with super-hydrophilic properties obtainable by this process, according to claim 11. The invention further relates to an apparatus for carrying out the above process, according to claim 16.

The main but not exclusive purpose for providing super-hydrophilic properties to a substrate is to impart its anti-fogging and/or self cleaning behaviour.

The problem of fogging is widely known for a plurality of applications. It refers to the phenomenon that condensing water droplets accumulate on the surface of a cold object when placed in a humid environment. If the object is transparent, the view through the object is disturbed due to the incoming light being scattered by the droplets.

The problem has been addressed by super-hydrophilic coatings. Surfaces on which such a coating is applied have a water droplet contact angle of below 5° in a short time, i.e. about 0.5 to 0.8 seconds, and prevent the formation of light scattering water droplets on the surface due to a nearly instantaneous, sheet-like wetting of the surface.

Super-hydrophilic coatings are mainly based on polymers, metal-oxides or a combination of them. Metal-oxide based super-hydrophilic coatings are for example described by Machida, M. et al, J. Mater. Sci., 1999, 34, 2569.

Pure metal-oxide coatings have the advantage of a high stability and can be utilized in rough environments. The super-hydrophilicity of the metal-oxide based coatings is obtained either by providing a textured surface in the micro- or nano-scale ("nanowicking") or by the material properties of the metal-oxides itself.

For example, titanium dioxide based super-hydrophilic coatings have been suggested by Wang, R. et al, Nature 1997, 388, 431. The super-hydrophilicity of such coatings is attributed to the photochemical activity of titanium oxide and amphiphilic surfaces are obtainable by controlling the UV radiation. In fact, without UV the titanium oxide coating loses its super-hydrophilicity in the range of hours or days.

Also, super-hydrophilic silicon dioxide based coatings have been reported. Such coatings have a high surface concentration of hydroxyl groups, as it is the case for flame-made silicon dioxide, as referred to in Zhuravlev, L.T. et al, Colloid Surf. A-Physicochem. Eng. Asp., 2000, 173, 1).

Conventional metal-oxides coating processes can be subdivided in wet- and dry-methods.

A wet method is for example described in KR-A-2007013712 relating to a process comprising the step of applying a silica solution by flow-coating, spin-coating or dip-coating, or in CN-A-1840497, according to which a glass surface is etched or laser drilled before being coated with a coating material.

Wang, R. et al., T. Advanced Materials 1998, 10, (2), 135ff relates to the synthesis of TiO₂ films by spray coating on various solid substrates, and Guan, K.S. et al, Surface & Coatings Technology 2003, 173, (2-3), 219-223 relates to a dip coating process. Further wet methods are described by Cebeci, F.C. et al., Langmuir 2006, 22, (6), 2856-2862 and by Gan, W.Y. et al., Journal of Materials Chemistry 2007, 17, (10), 952-954.

Wet-methods generally have the advantage of a relatively high coating mechanical stability, due to utilization of binders, but require long process times in the range of hours or days, large number of steps and have poor reproducibility of the coating morphology and of the amount of material used. Furthermore, synthesis of ultrafine nanoparticles set further constraints to such wet-methods for example with regard to the calcination temperature and time, as well as to the concentration and component of the precursor solutions.

The drawbacks of wet methods have been addressed by dry methods, among which several methods such as sputtering (Sheng, L. Y. et al, Sens. Actuators, B, 1998, 49, 18), spray pyrolysis (Korotcenkov, Sens. Actuators, B, 2005, 107, 209) cluster beam deposition (Mazza. T., et al. Appl. Phys. Lett., 2005, 87, 103), classified aerosol deposition (Kennedy, M.K., J. Appl. Phys., 2003, 93, 551) or combustion chemical vapor deposition (Liu, Y. et al. Chem. Mat., 2005, 17, 3997) have been suggested. However, only few of these methods can be scaled up to deposit on large surfaces and at low cost.

DE 10 2004 016 436 relates to a process of producing a multi-layer system having photocatalytic activity. The process comprises the step of depositing a silicon containing layer on a substrate by a flame pyrolysis process. According to this process, the distance between the burner and the substrate onto which the layer is to be applied is 5 mm. Under these conditions, the precursor is deposited on the substrate where it is converted to a silicon oxide layer. The main purpose of the silicon oxide layer according to DE 10 2004 016 436 is to work as a barrier for the diffusion of alkali ions from the substrate into the photocatalytic layer. The silicon oxide layer obtained by the process according to DE 10 2004 016 436 is however not super-hydrophilic and, accordingly, anti-fogging properties are nowhere mentioned in this document.

Wang R. et al. relates to a process for manufacturing anti-fogging and self-cleaning coatings, said process comprising the deposition of a TiO₂ and SiO₂ coating onto a glass surface by DC reactive magnetron sputtering and RF magnetron sputtering. The process is relatively time-consuming, costly and poorly scalable.

Given the mentioned drawbacks of conventional coating techniques, the object of the present invention is to provide a fast, simple and flexible process for providing super-hydrophilic properties to a substrate, said super-hydrophilic properties being at least comparable to the ones obtained by the conventional coating techniques. As generally transparent or specular substrates, such as glass or mirrors, are provided with super-hydrophilic properties in order to impart their anti-fogging and/or self-cleaning behaviour, it is a further object of the present invention that providing such a substrate with the properties mentioned does not interfere with its transparency.

The object is solved by the process of claim 1. Preferred embodiments are given in the dependent claims.

According to the present invention, the coating is applied by combustion and/or pyrolysis of a precursor of the coating material in a flame. The combustion or pyrolysis of the present invention includes for example methods known to the skilled person as flame spray pyrolysis (FSP), flame assisted spray pyrolysis (FASP), liquid flame spray (LSF) etc. A flame spray pyrolysis per se is for example described in WO 2006/061103 (page 7, lines 16 to 28), the content of which is incorporated herein by reference.

By the combustion or pyrolysis according to the present invention, the precursor is converted to the hydrophilic and/or photocatalytic coating material and a vapour and/or an aerosol comprising the coating material is produced. The coating material is then deposited from the vapour or aerosol, respectively, to the surface of the substrate.

Applying of a coating of a hydrophilic and/or photocatalytic coating material according to the present invention can thus be achieved by two main routes reliant on flame parameters, precursor composition and substrate temperature.

According to a first route, complete reaction of the precursor in the flame leads to formation of a vapour of the coating material which is deposited on the substrate similar to physical vapor deposition (PVD).

According to a second route, super saturation of the vapour leads to homogeneous nucleation of coating material particles in the gas phase. The coating material comprised in the resulting aerosol is deposited onto the substrate by Brownian motion, thermophoresis and impaction.

It has surprisingly been found that the routes according to the present invention result in coatings having superior super-hydrophilic properties compared to routes similar to chemical vapor deposition (CDV), i.e. in which the precursor is deposited on the substrate before being converted to the coating material.

The coatings according to the present invention have also been found to be superior over coatings obtained by routes in which droplets of the precursor impact onto the substrate's surface before being converted to the coating material, since the coatings obtained by these latter routes tend to the formation of cracks and uncontrolled morphologies.

The process of the present invention is extremely fast. Thus, a substrate can be provided with super-hydrophilic properties in less than about 30 seconds.

In general, the coating material of the present invention is a metal oxide and/or a metalloid oxide. In particular, it is selected from the group consisting of titanium dioxide, silicon dioxide and a combination thereof. Any kind of precursor for the given coating material can be employed. Typically, titanium (IV) isopropoxide is used as a precursor for titanium dioxide and hexamethyldisiloxane is used for silicon dioxide.

The process of the present invention is mainly but not exclusively used to impart the anti-fogging behaviour of the substrate. The imparting of the anti-fogging behaviour also encompasses the providing of anti-fogging properties where no such properties are present.

Depending on the coating material employed, the process of the present invention does not only allow for anti-fogging but also for self-cleaning properties to be provided. This is in particular the case where the substrate is coated with titanium dioxide which is photocatalytic. The photocatalytic effect of titanium dioxide (which is responsible for the anti-fogging and the self-cleaning properties) is, however, only activated by exposure to UV light. According to the present invention, a coating comprising both titanium dioxide and silicon dioxide can now be applied in a simple manner. Thus, the invention allows providing both anti-fogging and self-cleaning properties to a substrate, with the anti-fogging properties being independent on UV light exposure.

It has further been found that the coatings applied according to the present invention do not interfere with the transparency of a substrate such as a glass or a mirror; spectrometry of coated glass confirmed 100% transparency of the visible light.

Due to the fact that the precursor is converted to the coating material before being deposited on the substrate, coatings having specific nanostructures can be obtained. This is particularly the case if titanium dioxide is used as coating material.

According to a particularly preferred embodiment of the invention, an aerosol comprising nanoparticles of the coating material is produced, said nanoparticles being deposited on the substrate's surface, thereby forming a nanostructure. In addition to the respective properties of the coating material itself, this nanostructure is assumed to attribute considerably to the high super-hydrophilicity of the coating.

For carrying out the process of the present invention, the distance between the nozzle of the burner, which generates the flame, and the substrate is generally greater than the length of the flame. Typically, the distance is in the range of centimetres, preferably about 20 cm. Thus, the flame of the burner does not directly impinge on the substrate. Due to the relatively great distance between the burner and the substrate, the precursor is converted to the coating material - thereby forming a vapour and/or aerosol comprising the coating material - before it is deposited on the substrate.

The relatively great distance between the burner and the substrate further allows the temperature to which the substrate is exposed to be kept on a relatively low level. According to the present invention, all kind of substrates, including heat-sensitive substrates, can thus be provided with super-hydrophilic properties. In this regard, the maximum temperature on the substrate's surface during deposition of the coating material is preferably below the melting or breaking temperature of the material of the substrate. The specific temperature depends from the substrate and may vary from room temperature for deposition on polymers to several hundreds degrees (> 1000 °C) for deposition on melted glass. Given the relatively great distance between the burner and the substrate, the present invention also allows the precursor to be in liquid form without having the problem of droplets impacting on the substrate's surface leading to the drawbacks mentioned above. The possibility of using precursors both in liquid and gaseous form is one aspect contributing to the flexibility of the process of the present invention.

According to a further particularly preferred embodiment, the stability of the coating applied can be vastly increased by additionally sintering (or annealing) it. If a glass substrate is subjected to the process of the present invention, the temperature of the sintering step typically ranges from about 200 to about 1100°C, preferably from about 600 to about 1000 °C, most preferably from about 800 to about 900 °C. This sintering step is preferably carried out in situ, for example by diminishing the distance between the nozzle of the burner and the substrate and by impinging a spray flame devoid of coating material or its precursor onto the coating formed on the substrate. If for steps a) and b) the distance between the nozzle of the burner and the substrate is about 20 cm as given above, the distance is for example set to about 14 cm for the sintering step c). By the sintering, a highly water resistant coating is obtained.

In general, the substrates which are provided with anti-fogging properties according to the present invention are substantially transparent, such as a glass, or specular, such as a mirror. Alternatively, also non-transparent or non-specular substrates can make use of the benefits achieved by the present invention. For example, power lines can be provided with anti-fogging properties according to the present invention, thereby vastly reducing electrical discharge phenomena caused by condensed water droplets. This application of the invention is of particular interest with regard to eliminating noise emissions accompanying such corona discharge phenomena.

The present invention further relates to an object having anti-fogging properties obtainable by the process defined above.

As will be shown in detail in the examples, the coating obtained by the process of the present invention is porous. Depending on the coating material used, the porosity is preferably in the range from about 90 to about 99%, most preferably about 97 to about 98% as computed from the bulk thickness measured by light absorption or mass and the visible thickness as measured by SEM. For titanium dioxide coatings, for example, a porosity of up to 98 % can be achieved. It is assumed that the porosity of the coating contributes considerably to the enhanced super-hydrophilicity obtainable by the present invention, in addition to the properties of the coating material per se.

According to a further preferred embodiment, the coating has a thickness ranging from 50 to 1000 nm. Such a coating does not interfere with the transparency of a substrate, such as a glass or a mirror.

Given the different coating structures obtained by using different coating materials, the present invention also relates to an object wherein the coating comprising titanium dioxide has a lace-like structure and to an object wherein the coating comprising silicon dioxide has a fiber-like structure. As will be shown in the examples, the fibers thereby have a diameter in the range of about 5 to about 40 nm, preferably about 10 nm, and a length up to about 1000 nm, preferably up to about 600 nm.

The present invention further relates to an apparatus specifically designed for carrying out the process of the present invention. Said apparatus comprises a burner generating a flame and a substrate holder. Thereby, the burner and the substrate holder are arranged such that the substrate is not impinged by the flame during deposition of the coating material. This allows a vapour and/or an aerosol comprising the converted coating material to be produced before deposition on the substrate.

The invention is described in detail by way of the examples given below. It is thereby referred to the Figures of which
Fig. 1 shows schematically three main routes for applying a coating onto a substrate using flame spray pyrolysis;
Fig. 2 shows a scatter electron microscopy (SEM) image of a TiO₂ coating applied according to the present invention with a deposition time of 10 seconds (Fig. 2a) and 15 seconds (Fig. 2b), respectively;
Fig. 3 shows a scatter electron microscopy (SEM) image of a SiO₂ coating applied according to the present invention with a deposition time of 15 seconds (Fig. 3a), and a corresponding magnification thereof (Fig. 3b);
Fig. 4 shows a three-dimensional representation of a topography of a SiO₂ coating applied according to the process of the present invention;
Fig 5 shows a scatter electron microscopy (SEM) image of a coating comprising SiO₂ and TiO₂ (SiO₂-TiO₂ coating) applied according to the present invention with a deposition time of 15 seconds;
Fig. 6 is a graphical representation of the transmittance spectrum for a SiO₂ coating, a TiO₂ coating and a SiO₂-TiO₂ coating obtained according to the process of the present invention with a deposition time of 20 seconds;

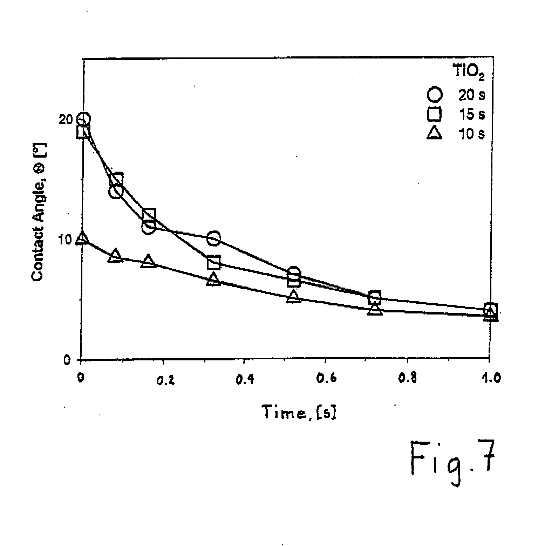

Fig. 7 is a graphical representation of the contact angles (9) of 0.5 µl water droplets on a substrate coated with TiO₂ according to the present invention as a function of contact time for a deposition time of 10, 15 and 20 seconds, respectively;
Fig. 8 is a graphical representation of the contact angles (θ) of 0.5 µl water droplets on a substrate coated with a combination of TiO₂ and SiO₂ according to the present invention as a function of contact time for a deposition time of 10, 15 and 20 seconds, respectively;
Fig. 9 is a graphical representation of the contact angles (θ) of 0.5 µl water droplets on a substrate coated with SiO₂ according to the present invention as a function of contact time for a deposition time of 10, 15 and 20 seconds, respectively;
Fig. 10 is a graphical representation of the contact angles (θ) of 0.5 µl water droplets on a substrate coated with TiO₂ and a combination of TiO₂ and SiO₂ (SiO₂-TiO₂) according to the present invention, where the substrate has not been exposed to UV light; and
Fig. 11 is a graphical representation of contact angles at 0.52 seconds of 0.5 µl water droplets with *as prepared* and *in situ* sintered TiO₂ and SiO₂ coatings, respectively, as a function of deposition time after being flushed with water.

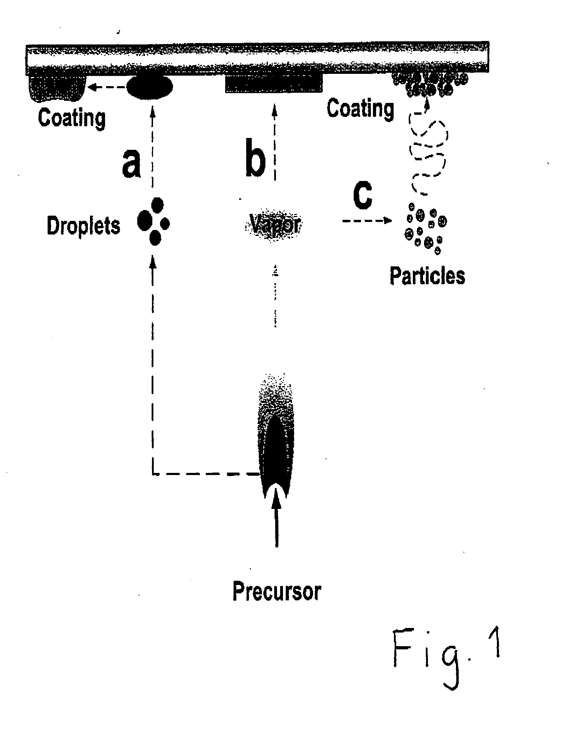

Three main routes for applying a coating on a substrate by FSP are shown in Fig. 1.

Droplet deposition, indicated as route a in Figure 1, occurs if the liquid precursor impacts onto the substrate surface and there it is converted to the final coating material. Such solid layers tend to cracks - formation and uncontrolled morphologies.

According to route b of Figure 1, a vapor is formed. Said vapor can comprise the precursor which can after deposition to the substrate be converted to the final coating material similar to chemical vapor deposition (CDV). In contrast, if the precursor is converted to the coating material in the flame, a vapor comprising the coating material, specifically the metal oxide and/or metalloid oxide, is formed, which is then deposited on the substrate similar to physical vapor deposition (PVD). Both for CVD - and PVD - like depositions, it is possible to obtain a large number of shapes and morphologies with sufficient reproducibility.

A third main route shown by route c of Figure 1 consists in the super saturation of the vapor which leads to homogeneous nucleation of particles in the gas phase. The resulting aerosol is deposited onto the substrate by Brownian motion, thermophoresis and impaction. Such coatings are characterized by high porosity of up to 98%.

In the examples according to the present invention, titanium oxide, silicon oxide and silicon - titanium oxides coatings were obtained using the PVD like alternative of route b and by route c, respectively. In both routes, the precursor is converted to the coating material before being deposited on the substrate's surface.

### Examples

Specifically, the examples were carried out by using a flame spray pyrolysis (FSP) reactor (or burner) in combination with a substrate holder, as for example described in L. Madler et al, Sens. Actuators, B, 2006, 114, 283, for synthesis and direct deposition of TiO₂, SiO₂ and a combination of SiO₂ and TiO₂ (SiO₂-TiO₂) to provide nanostructured coatings onto glass substrates of 7.5 cm x 2.5 cm (VWR, ECN 631-1550). These coatings were mechanically stabilized by in situ annealing with a xylene-fed, particle-free spray flame.

The TiO₂ and SiO₂ precursors were prepared as follows: Titanium (IV) Isopropoxide (TTIP, Aldrich, purity > 97% ) and hexametyldisiloxane (HMDSO, Aldrich, purity > 99%) were mixed, as dictated by the final SiO₂ molar content (0 - 40 - 100%), and diluted in xylene (Fluka, purity > 98.5%) with a total metal (Ti and Si) concentration of 0.05 mol/l. This solution was supplied at a rate of 5 ml/min through the FSP nozzle and dispersed to a fine spray with 5 1/min oxygen (pressure drop 1.5 bar). That spray was ignited by a supporting ring - shaped premixed methane / oxygen flame (CH₄ = 1.5 l/min, O₂ = 3.2 l/min). Additional 5 l/min sheath oxygen was supplied from an annulus surrounding that flame to assure excess oxidant flow.

The temperature behind the substrate was measured by an n - type thermocouple. During deposition the burner - substrate (BS) distance was 20 cm and the substrate reached a maximal temperature of 550°± 20°C. The coatings were annealed *in situ* by lowering the substrate holder to BS = 14 cm and by impinging a particle-free (no metal precursor) xylene-fed spray flame onto the film for 15s. During in situ annealing the substrate reached a maximal temperature of 820 ± 20°°C. The supporting flame and sheath oxygen flows were those used during FSP deposition. The xylene feed rate was 12 ml/min resulting in a maximum of 220 °C behind the substrate. Particles at different heights above the burner (7, 11, 15 and 20 cm) were collected by thermophoretic sampling onto *Pelco* grids of 3 mm.

Transmission electron microscopy was conducted in a Hitachi H600, operated at 100 kV. The morphology, patterning characteristics and thickness of the deposited layers were investigated by SEM with a LEO 1530 Gemini (Zeiss/LEO, Oberkochen) and a Tecnai F30 microscope (FEI (Eindhoven); field emission cathode, operated at 300 kV). Atomic Force Microscopy (AFM) was used also to investigate the coatings morphology. AFM height and phase images of the coated glasses were collected using an Asylum Research MFP-3D AFM microscope in tapping mode. AFM images were obtained with scan sizes ranging from 600 nm to 5 µm and elaborated with WSxM software. Throughout the analysis, n-doped silicon tips with a resistivity of 0.01-0.025 Ω cm were used (Nanosensors, Neuchatel, Switzerland, type PPP-NCHR-W), The AFM imaging was performed at room standard conditions. The transmittances of the coated glasses have been measured using a Varian Cary 500, UV - vis spectrophotometer.

The size distribution of the flame aerosol was also measured by Scanning Mobility Particle Sizer (SMPS). The SMPS consists of a differential mobility analyzer (DMA: TSI model 3077) and a condensation particle counter (CPC; TSI model 3022). Before characterization, the aerosol was diluted by an ejector diluter (dilution ratio ∼40). A sampling flow rate ratio of 0.3 - 3.0 l/min and measurement cycle of 2.5 min for each size spectrum were used. The average size spectrum over 5 measurements was plotted.

Drop contact angle measurements were performed in air utilizing deionized water with a contact angle measurement system (G10, *Krüss*). A water droplet of 0.5 µl was dropped on the coated substrate using a glass syringe with a nozzle of 0.5 mm (*Fortuna Optima,* 1 ml). Contact angle values were calculated from dynamic video files obtained with a CCD camera that captured 25 frames per second. The error in the contact angle measurement was ± 3°, due to the non - complete sharpness of the images taken from the video file. For the measurement in the dark, a UV - filter (hama - UV - 390 - Sperrfilter) has been placed in front of the light source while the substrates were kept in the dark for 50 hours.

### Coating with titanium dioxide (TiO₂)

In particular, titanium oxide coatings are obtained by deposition of air - born nanoparticles as described above for route C. In fact, TiO₂ nucleates early in the flame and at 7 cm height above the burner (HAB) particles with a visible diameter of 3 - 5 nm are collected by thermophoretic sampling. At higher magnification a set of lattice fringes has been found throughout the particle indicating high crystallinity. The inter - fringes distance is 3.57 Å which is in good agreement with anatase (101) crystallographic plane.

At 11 cm HAB, the TiO₂ particles are still non - agglomerated, their visible size is increased slightly while their concentration is decreased in comparison to 7 cm HAB, due to coalescence and air entrainment. In contrast, at 15 and 20 cm HAB large agglomerated structures are collected. Their size ranges from tens to hundreds of nanometers with a count mean diameter (CMD) of 57 nm and a geometric standard deviation (GSD) of 1.56. They are made of a large number of primary particle below 10 nm which have agglomerated in the flame by Brownian coagulation. Although some of these particles have sintered together forming chemical bonds (aggregates) some others are hold together by weak physical bonds (agglomerates) and are dispersed easily.

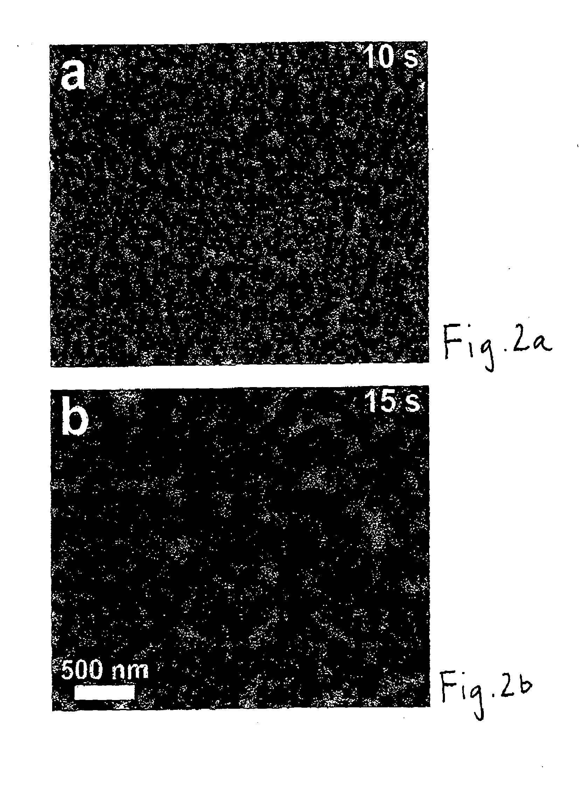

As discussed above, deposition of air - born (TiO₂) particles occurs by Brownian motion, thermophoresis and impaction. Fig. 2 shows top views of TiO₂ coatings on glass substrates respectively for 10 s (Fig. 2a) and 15 s (Fig. 2b) deposition time. The coatings have high porosity and surface roughness. After 10 s deposition, the substrate surface is still visible and polydisperse nanostructures are randomly distributed on it. These nanostructures size ranges from tens to hundreds of nanometers in agreement with the polydispersity of TiO₂ agglomerate size observed at 20 cm HAB. Furthermore, the randomness nature of Brownian deposition increases further the polydispersity of the deposited structures.

Increasing the deposition time from 10 to 15 s increases the surface coverage and the nanostructures size forming a rough network of nanoparticles, said network having a lace - likes morphology, as shown in Fig. 2b.

### Coating with silicon dioxide (SiO₂)

Coating with SiO₂ led to drastically different morphologies and structural properties than TiO₂. At 7 cm HAB, it was not possible to detect any particles as it was the case for TiO₂ and instead an amorphous film was deposited on the TEM - grid. Even at 20 cm HAB a large amount of amorphous material was coating the TEM - grid and any particles were detected. At higher magnification, this amorphous film is smooth and continuous suggesting heterogeneous nucleation on the TEM - grid instead of homogenous particles nucleation in the flame. Indeed, the striking difference between SiO₂ and TiO₂ thermophoretic sampling indicates two differentiate synthesis routes (Fig. 1). While TiO₂ coats the substrates by deposition of air - born particles as shown by route c of Fig.. 1, SiO₂ - coatings are formed by the PVD-like alternative of route b.

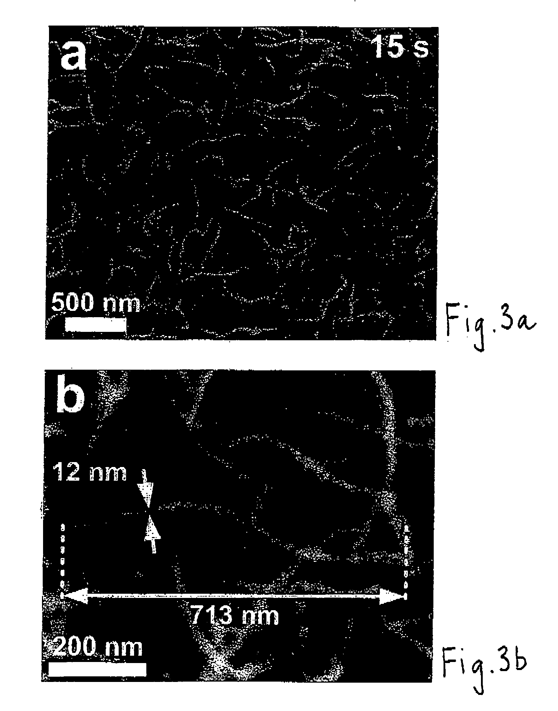

This was confirmed further by SEM analysis of SiO₂ - coatings, as shown in Fig.s 3a and 3b. After 15 s deposition time (Fig. 3a), a highly porous network of nanostructures is self -assembled on the substrate surface. Its morphology is drastically different than the one obtained by TiO₂ - coating of same deposition time (Fig. 2b). In fact, agglomerated nanostructures made of several primary particles were not formed as for TiO₂. Instead, SiO₂ formed thin, elongated, continuous nanostructures (Fig. 3a). The (substrate) surface coverage obtained by this SiO₂ structures has been found to be lower than TiO₂ ones which has implication on the anti - fogging properties. At a higher magnification given in Fig. 3b these thin structures are identified as fibers with diameters in the range of about 10 nm and lengths up to about 1000 nm. This small thickness/length ratio (t/l = 0.001) of the fibers (Fig. 3b) confirms that the SiO₂ is applied using the PVD-like alternative of route B given in Fig. 1. In fact, such extreme size features are not common for flame-made materials. Prior to the present invention, only relatively moderate t/l ratio (0.2) were achieved by flame spray pyrolysis and required heavily doping of ZnO with Sn or In.

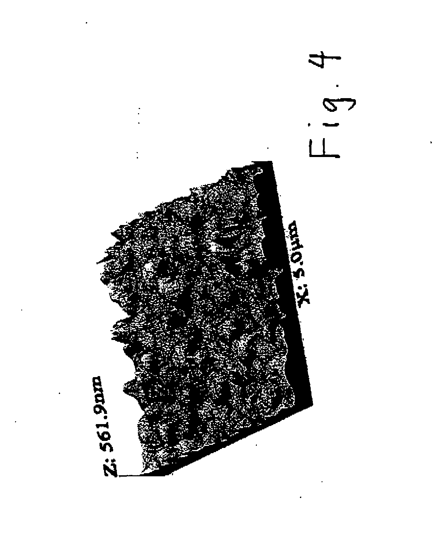

An important feature of these *in situ* grown structures is their high mechanical stability as they are not only physically but also chemically bonded to the substrate. Due to their high adhesion and cohesion it is possible to accurately map the SiO₂ - coatings morphology by atomic force microscope (AFM). Analysis of a SiO₂ - coating deposited for 15 s (Fig. 4) shows a highly porous surface with a maximal thickness of 561.9 nm. The surface is rough with huge height gradients. Chain structures extend over the substrate surface resembling the fibers observed by SEM. Nevertheless, such structures are too width (≈ 200 nm) to be single fibers. In fact, surface topography along one of this structure reveals a discontinuous height profile indicating several overlapping fibers.

The coating thickness was decreased from 561.9 to 246.9 nm with decreasing deposition time from 15 to 10 s. The roughness of the 10 and 15 s SiO₂ - coatings are similar and also their morphology.

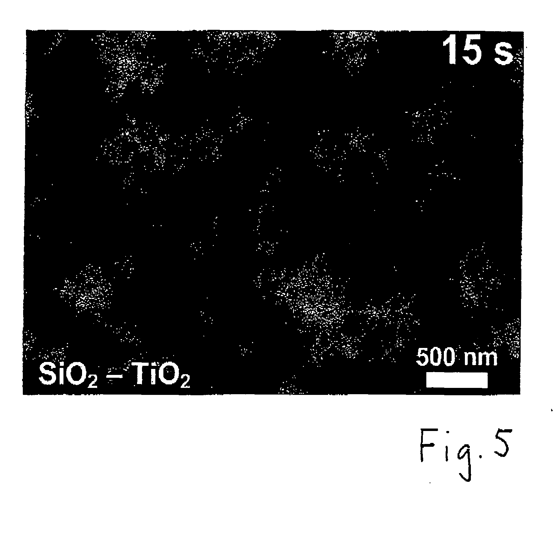

Synthesis of SiO₂ - TiO₂ (40% mol Si) coatings resulted in particles nucleation and deposition according to route c of Fig. 1 as observed for TiO₂ synthesis. The resulting morphology shown by the SEM morphology given in Fig. 5 was similar to the TiO₂ ones with agglomerated structures extending over the substrate surface. A slight difference is observable in the shape of these agglomerates. In contrast to the soft TiO₂ structures, the SiO₂ - TiO₂ ones tend to form spike - like endings.

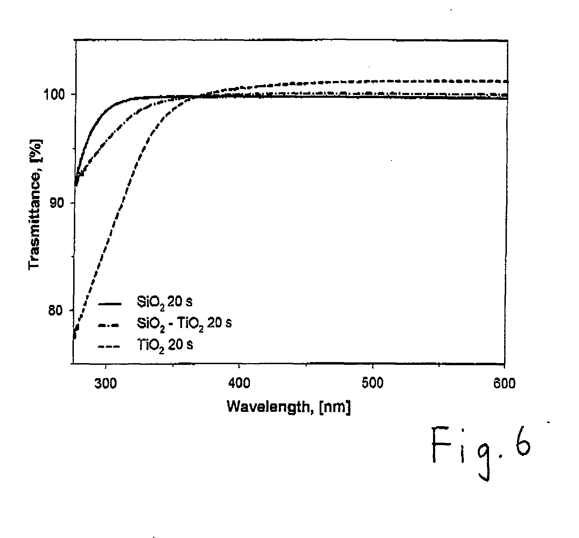

As shown in Fig. 6, all coatings were completely transparent in the visible range (380 to 750 nm) up to a deposition time of 20 s. The TiO₂ coatings (broken line) started absorbing around 365 nm in agreement with their bandgap of 3 - 3.1 eV. Above this wavelength (365 nm), the TiO₂ - coating demonstrated a slight anti - reflection behavior increasing the transmittance from 100 to 102%.

The SiO₂ coatings (continuous line) were completely transparent down to 323 nm which is in agreement with their higher bandgap (8.9 eV) than TiO₂ (3 - 3.1 eV) . The SiO₂ - TiO₂ coatings (dotted line) had an intermediate transmittance spectrum between TiO₂ and SiO₂ ones.

### Wetting properties

The coatings' wetting properties were analyzed by water droplet contact angle (θ) measurements. All coatings increased the surface hydrophilicity decreasing θ from 23° to 0° (not shown). Nevertheless, the time resolved θ measurements revealed different performances as a function of deposition time (thickness, roughness) and measurement condition (radiation). In order to obtain anti - fogging surfaces θ should be below 10 - 5° in 0.5 s. Under normal solar radiation all the *as prepared* coatings (TiO₂, SiO₂ - TiO₂ and SiO₂) had similar performances as shown in Fig.s 7, 8 and 9, respectively) with θ reaching 10 - 5° in 0.5 s.

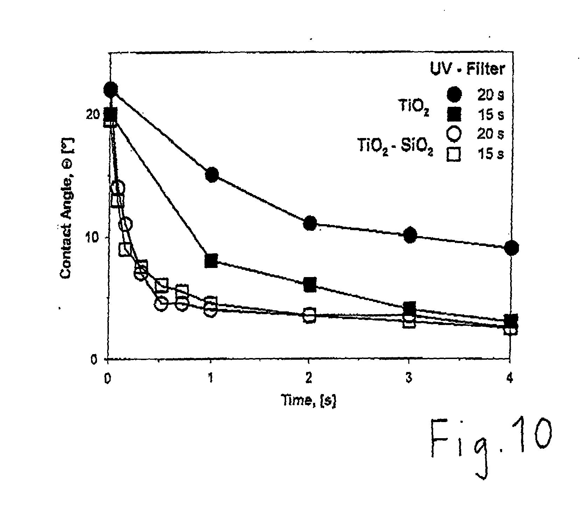

However, as shown in Fig. 10 the TiO₂ - coatings lost their super - hydrophilicity after TiO₂ - deactivation which was obtained by placing the substrate in the dark for 50 h and performing the measurement with the aid of a UV filter. Once the TiO₂ was deactivated, the contact angle measured after 1 s increased from 4° under normal solar radiation to 8° and 15° for the 15 and 20 s deposition time respectively. A contact angle below 5° was not reached for the 20 s coating and it was reached for the 15 s ones only after 3 s. This drastic θ increase indicates that TiO₂ coatings super - hydrophilicity is attributed to photocatalytic activity of TiO₂. In fact, water molecules are chemisorbed on Ti³⁺ sites generated by photoreduction of Ti⁴⁺ thereby inducing a super - hydrophilic behavior of the TiO₂ surface.

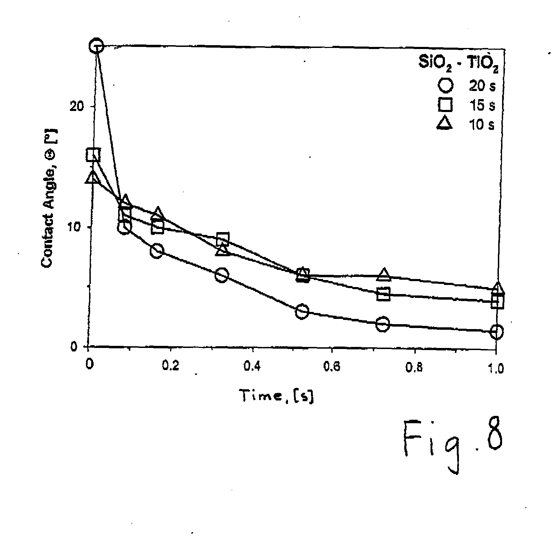

This conclusion was supported further by contact angle analysis of SiO₂ - TiO₂ coatings. As discussed above, such coatings have same morphology as the TiO₂ ones, therefore the effect of surface roughness and porosity is expected to be comparable. In contrast to TiO₂, SiO₂ - TiO₂ compounds increase the surface acidity inducing super - hydrophilicity of the nanoparticles also without solar radiation. In fact, under normal solar radiation the SiO₂ - TiO₂ coatings induced a super - hydrophilic surface behavior reaching contact angles of 10 - 5° after 0.5 s as shown in Fig. 8. The SiO₂ - TiO₂ coatings preserved their super - hydrophilicity also after TiO₂ deactivation. In fact, the contact angles after 0.52 s of the deactivated SiO₂ - TiO₂ coatings was 6 and 4.5° according to Fig. 10 (empty square and circles) for the 15 and 20 s deposition times respectively. This striking difference between TiO₂ (full symbols in Fig. 10) and SiO₂ - TiO₂ (empty symbols in Fig. 10) clearly shows that the super - hydrophilic properties of the nanoparticles determine the wetting properties of the coatings. As TiO₂ super - hydrophilicity is due to its photocatalytic activity the TiO₂ - coatings are super - hydrophilic only if TiO₂ is activated. In contrast, SiO₂ - TiO₂ coatings are super - hydrophilic also if the TiO₂ is deactivated as their super - hydrophilicity originates from the enhanced surface acidity.

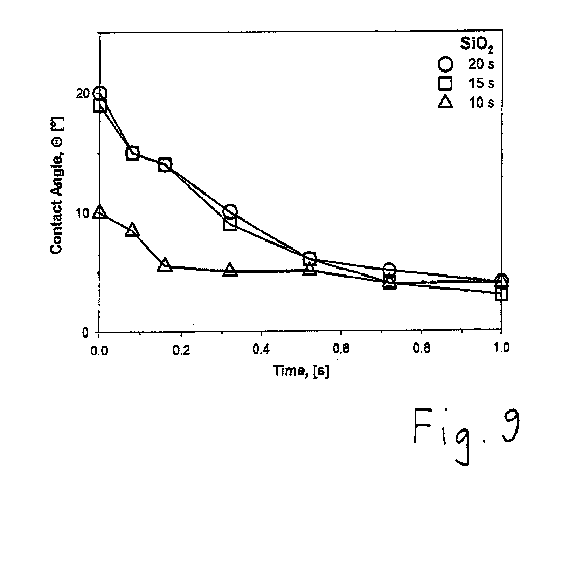

The SiO₂ - coatings had similar properties to the SiO₂ - TiO₂ ones. The contact angle given in Fig. 9 decreased rapidly reaching 6 - 5° after 0.52 s for all deposition times. These super - hydrophilic properties of SiO₂ - coatings are attributed to the super - hydrophilicity of flame - made SiO₂ due to the high surface concentration of hydroxyl groups. In fact, although the SiO₂ - coatings morphology, constituted of fibers, is drastically different from TiO₂ and SiO₂ - TiO₂ ones, made of agglomerates, their wetting properties are comparable due to the super - hydrophilicity of the nanostructures. In contrast to the photocatalyticly active TiO₂, the SiO₂ super - hydrophilicity was preserved also without UV radiation as it originates from its high surface concentration of hydroxyl groups.

### echanical tability

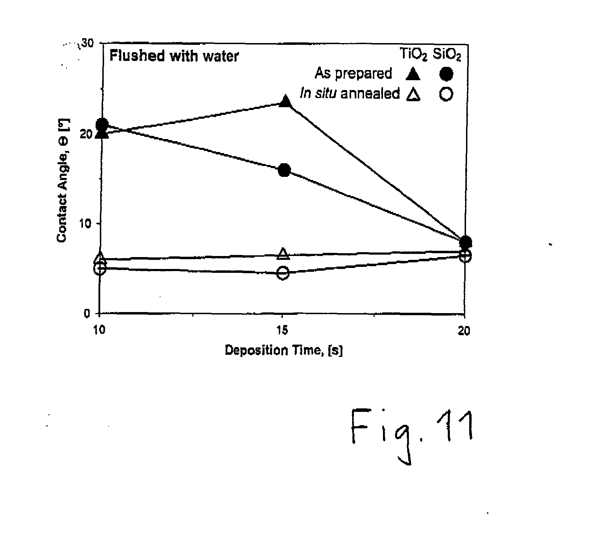

The coatings stability was investigated by flushing them with 5 ml water, drying and measuring the contact angle again. Figure 11 shows the contact angle after 0.52 s for the *as prepared* coatings (full symbols) and the in situ annealed ones (empty symbols) after flushing with water. The contact angle (after 0.52 s) of the 10 s TiO₂ coatings (full triangles in Fig. 11) increased from 6.5 to 20.2° due to flushing with water. The contact angle of the 15 s TiO₂ coating (full triangles in Fig. 11) was also increased above 20° after water flushing while the 20 s ones increased only to 8°. A similar trend was observed for SiO₂ (full circles in Fig. 11). Indeed, the capillary forces are high enough to rearrange the SiO₂ morphology as observed by SEM analysis of the *as prepared* SiO₂ coating after flushing. After flushing, the fibers are not uniformly distributed on the substrate surface anymore as the *as deposited* ones were and leave some of the substrate uncoated. Nevertheless, once a critical mass has been deposited (20 s) such surface restructuring does not influence the super - hydrophilic properties as observed for the SiO₂ and TiO₂ coatings (full symbols in Fig. 11). The stability of the in situ annealed coatings was high enough to withstand water flushing independently from the deposition time (empty symbols in Fig. 11).

### Anti - ogging Properties

The anti - fogging properties of the in situ annealed coatings were tested by placing the glass substrate in a vapor stream 30 cm above boiling water. The transparent uncoated substrates fogged completely in few seconds due to condensation of small water droplets on the substrate surface. Already after 10 s deposition the surface fogging was decreased by all coatings. This effect is attributed to the super - hydrophilicity of the coating which avoids formation of water droplets on the substrate surface. Nevertheless, some droplets are still formed for the 10 s SiO₂ and SiO₂ - TiO₂ coatings thereby partially fogging the glass. This is attributed to the smaller substrate surface coverage of the SiO₂ - coatings than of the TiO₂ ones which was observed by SEM analysis. Increasing the deposition time to 20 s all the coatings completely avoid fogging of the glass substrates. This confirms that a minimal surface coverage (20 s) is preferred to avoid formation of small droplets on the substrate surface.

With regard to the conventional wet - route methods for providing anti-fogging properties, the process of the present invention has the advantage of a drastic reduction of the process time from hours of the methods to a few seconds.

The process of the present invention has the further advantage that the super-hydrophilic coating applied on the substrate can be stabilized by a rapid sintering (annealing) step. Also, its scale - up feasibility makes it more favourable than the conventional methods. Furthermore, the easy feasibility of synthesizing complex composites increases the functionalities of such coatings as observed for SiO₂ - TiO₂ which possesses both the anti - fogging properties of SiO₂ - coatings and the self - cleaning photocatalytic effect of TiO₂ coatings.

## Claims

1. Process for providing super-hydrophilic properties to a substrate by applying a coating comprising a photocatalytic and/or a hydrophilic coating material to a surface of the substrate, wherein the process comprises the steps of
a) combustion and/or pyrolysis of a precursor of the coating material in a flame, thereby producing a vapour and/or an aerosol comprising the coating material and
b) deposition of the coating material from the vapour or aerosol, respectively, to the substrate's surface.

2. The process according to claim 1 for imparting the anti-fogging and/or self-cleaning behaviour of the substrate.

3. The process according to claim 1 or 2, wherein the coating material is a metal oxide and/or a metalloid oxide.

4. The process according to claim 3, wherein the metal oxide and/or metalloid oxide is selected from the group consisting of titanium dioxide, silicon dioxide and a combination thereof.

5. The process according to any of the preceding claims, wherein the aerosol comprises nanoparticles of the coating material, said nanoparticles being deposited on the substrate's surface.

6. The process according to any of the preceding claims wherein the maximum temperature on the substrate's surface during deposition of the coating material is below the melting or breaking temperature of the material of the substrate.

7. The process according to any of the preceding claims wherein the process comprises additional step
c) sintering of the coating applied.

8. The process according to claim 7 wherein the sintering of step c) is carried out at a temperature in a range from 200 to 1100°C, preferably from 600 to 1000 °C, most preferably from 800 to 900°C.

9. The process according to any of the preceding claims, wherein the precursor is in liquid form.

10. The process according to any of the preceding claims, wherein the substrate is substantially transparent or specular.

11. Object with super-hydrophilic properties obtainable by the process of any of the preceding claims comprising a substrate and a coating comprising a photocatalytic and/or a hydrophilic coating material on a surface of said substrate, said coating being porous.

12. The object according to claim 11, wherein the porosity of the coating is in the range from 90 to 99%, preferably from 94 to 99%, most preferably from 97 to 98%.

13. The object according to claim 11 or 12, wherein the coating has a thickness ranging from 50 to 1000 nm.

14. The object according to any of claims 11 to 13, wherein the coating comprising titanium dioxide has a lace-like structure.

15. The object according to any of claims 11 to 13, wherein the coating comprising silicon dioxide has a fiber-like structure.

16. Apparatus for carrying out the process according to any of claims 1 to 10 comprising a burner generating a flame and a substrate holder wherein the burner and the substrate holder are arranged such that the substrate is not impinged by the flame during deposition of the coating material.
